# EUROPEAN PATENT APPLICATION

(11) **EP 1 333 323 A2**
(43) Date of publication of application: **06.08.2003**
(21) Application number: 03002242.0
(22) Date of filing: 31.01.2003
(51) Int. Cl.: G03F 1/00, G03F 1/14, G21K 1/06

(54) **Self-cleaning reflective optical elements for use in x-ray optical systems, and optical systems and microlithography systems comprising same**

(30) Priority: 01.02.2002 JP 2002025160; 18.02.2002 JP 2002039990
(71) Applicant: NIKON CORPORATION, Tokyo (JP)
(72) Inventor: Murakami, Katsuhiko, Tokyo (JP); Ishiyama, Wakana, Tokyo (JP)
(74) Representative: Viering, Jentschura & Partner

(57) **Abstract**

Reflective optical components are disclosed for use in an X-ray optical system. The components (*e.g*., multilayer-film mirrors or reflective reticles) suppress contamination (*e.g*., carbon contamination) of their reflective surfaces during use. The multilayer film comprises alternating layers of first and second substances configured so as to confer high reflectivity to incident X-radiation (including perpendicularly incident radiation). The multilayer film includes a protective layer 1 formed of a material including a photocatalytic material) desirably formed on the uppermost layer of the multilayer film. If the optical component is a reticle, a patterned absorbing-body layer covers at least a portion of the multilayer film. A protective layer can be formed between the multilayer film and the absorbing-body layer, or in a blanketing manner over units of the absorbingbody layer and exposed portions of the multilayer film. Surficial contamination is removed by irradiating the protective layer with IR or visible light, in an oxygen containing atmosphere.

## Description

### Field

This disclosure pertains to multilayer-film reflective optical elements as used in "soft-X-ray" (SXR) optical systems, to SXR optical systems including one or more such optical elements, and to SXR projection-microlithography systems including such optical systems. "Projection microlithography" is a pattern-transfer technique widely used in the manufacture of microelectronic devices such as semiconductor integrated circuits, displays, and the like, and involves the projection of a pattern image onto a "sensitive" substrate such as a semiconductorwafer. This disclosure also pertains to methods for cleaning multilayer-film reflective optical elements in SXR optical systems, especially such methods that achieve *in situ* cleaning of individual multilayer-film reflective optical elements.

### Background

In recent years, the pattern-resolution limitations of "optical" projection microlithography have been increasingly apparent in the face of the relentless drive to find practical methods for fabricating microelectronic devices having active circuit elements of which the critical dimensions are less than 100 nm. Hence, a large effort is underway worldwide to develop a practical "next generation lithography" (NGL) technology capable of producing finer pattern-transfer resolution than obtainable with opticalmicrolithography. See Tichenor *et al., Proceedings SPIE* **2437**:292, 1995.

The resolution capability of optical microlithography is limited by the diffraction limit of the deep ultraviolet light (wavelength of 190 nm, for example) typically used in opticalmicrolithography. Since the diffraction limit is reduced with corresponding reductions in the wavelength of "light" used for microlithography, a key NGL technology currently under development utilizes a "soft X-ray" (SXR) wavelength (typically 11-14 nm), also termed "extreme ultraviolet" or EUV. Hence, EUV lithography (typically abbreviated "EUVL" in the current literature) is expected to exhibit a pattern-transfer resolution of 70 nm or less, which cannot be achieved with conventional optical lithography

The complex index of refraction "n" of a substance in the X-ray wavelength range is expressed by n = 1-ä-iâ, wherein ä and â are complex quantities that are each much less than unity. (Specifically, ä = (Nₐ/2 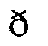 )r₀ë²ñ[(Z + *f*')/A], and â = ëì /4 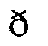 , wherein Nₐ is Avogadro's number, r₀ is the classical electron radius, ë = 2 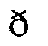 /k₁ = 2 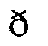 c/ù to the photon wavelength, Z + *f*' is the real part of the atomic scattering factor (in the forward direction) including the dispersion correction*f*', A is the atomic mass of the lens material, ì is the linear coefficient of attenuation of the lens material, and ñ is the density of the lens material.) The imaginary portion â pertains to X-ray absorption by the material. In any event, since ä and â are very small compared to unity, refractive indices in the X-ray wavelength range are very close to unity. As a result, transmission-refraction types of optical elements, such as conventional lenses, cannot be used with X-ray wavelengths (including SXR wavelengths). Rather, X-ray optical systems are constructed of reflective optical elements.

Optical components in conventional reflective optical systems for X-ray wavelengths can be grazing-incidence type and/or multilayer-film type. A grazing-incidence optical component exploits total reflection of X-rays incident to the component at high angles of incidence (*i.e*., highly oblique incidence at an incidence angle greater than the critical angle è_{c}, which is about 20° or less at ë = 10 nm). Unfortunately, grazing-incidence reflection tends to produce excessive aberrations in the reflected beam, and reflectivity tends to be very low atangles of incidence (è) less than è_{c}, including at normal (perpendicular) incidence. Here, "angle of incidence" (è) is the angle of an incident ray relative to a line perpendicular to the surface at the point of incidence.

Greatly improved surface reflectivity at è < è_{c} has been realized by forming a "multilayer film" (multilayer interference coating) on the surface of a mirror substrate. A multilayer film typically is formed of alternatingly superposed layers of at least two materials. The multilayer film is especially tailored for a particular wavelength of incident X-radiation, and typically presents many reflective surfaces (tens to hundreds, each formed at an interface between adjacent layers of different materials). The respective thickness of eachlayer is established, based on optical-interference theory, so as to achieve phase-matching of light waves reflected from the respective interfaces. To achieve the highest possible amplitude of reflection at each layer interface, the alternating layers typically are of a first material exhibiting a large difference between its refractive index at the X-ray wavelength being used and the refractive index of a vacuum (n = 1) and of a second material exhibiting a small such difference (also termed alternating"high-Z" (heavy-atom) and "low-Z" (light-atom) materials, as these terms are known in the art). The individual layers are very thin, and the multilayer film typically has a "period length" ("d" = combined thickness of each layer pair) of approximately ë/2 for normal-incidence reflection. Currently known examples of materials used for multilayer films are tungsten/carbon and molybdenum/silicon. Each layer can be formed using any of various thin-film-formation techniques such as sputtering, vacuum deposition, CVD, or the like. Since multilayer-film mirrors can reflect X-rays incident perpendicularly to the mirror, it is possible to construct, using such mirrors, an X-ray optical system exhibiting far less aberration than an optical system constructed ofgrazing-incidence mirrors.

In view of the manner in which multilayer film mirrors are made (with the multilayer film being tailored for a specific wavelength), reflection from such a mirror is highly dependent upon the incidence wavelength. The strongers reflection is achieved if the Bragg equation, 2dsinè = në, is satisfied. Hence, the multilayer film is configured carefully so as to satisfy this equation.

For example, a multilayer film can be made of molybdenum/silicon (Mo/Si), which exhibits high reflectivity to wavelengths on the long-wavelength side of the L-absorption end of silicon (12.6 nm). Hence, for an incidence wavelength near 13 nm, it is possible to construct, relatively easily, a multilayer-film mirror exhibiting high reflectivity (67 % or better) at perpendicular incidence (è = 0°).

X-ray optical systems normally are encased in a vacuum chamber, evacuated to high vacuum, to avoid absorption and attenuation of the X-radiation by air. Even in a vacuum chamber, however, X-ray optical components such as multilayer-film mirrors are vulnerable to contamination such as by carbon compounds that tend to deposit and accumulate on the components. This contaminant accumulation can be a serious problem in EUVL systems because the contaminants reduce the intensity of the EUV beam and adversely affect the optical performance of the system.

Carbon contamination of optical elements in X-ray optical systems arises from residual hydrocarbon-containing gases inside the vacuum chamber, despite the fact that the chamber is being evacuated continuously by a vacuum pump. Exemplary sources of the residual hydrocarbon-containing gas is the oil used in the vacuum pump, lubricants used in moving parts located inside the chamber, and materials and components used inside the chamber (*e.g*., insulation and coatings used on electrical components).

Also, in an EUVL system, the lithographic substrates imprinted with projected pattern images typically are semiconductor wafers coated with an exposure-sensitive material termed a "resist." The substrate is contained in a vacuum chamber during exposure. Irradiation of a resist by an EUV beam causes residual solvent and resin compounds in the resist to vaporize. The volatile hydrocarbon-containing gases produced by such vaporization drift about the vacuum chamber and deposit on various surfaces inside the chamber. Gaseous hydrocarbon molecules are especially adsorbed onto the surfaces of multilayer-film mirrors located inside the chamber. In the vacuum environment inside the chamber these adsorbed molecules tend to desorb and re-adsorb onto the multilayer-film surfaces, which works against large-scale accumulation of contaminants on the surfaces. However, whenever a multilayer-film surface (containing adsorbed hydrocarbons) is irradiated with an EUV beam, secondary electrons generated inside the mirror substrate tend to decompose the adsorbed hydrocarbon molecules, resulting in formation of tenacious carbon deposits. Over time, these carbon deposits form a layer of carbon on the multilayer-film surface. The thickness of the carbon layer increases in proportion to the dose of incident EUV radiation. Boller *et al., Nucl. Instr. and Meth.* **208**:273, 1983. Because it decreases the reflectivity of the multilayer-film surface, the carbon layer can seriously affect theoptical performance of the multilayer-film mirror, especially over time.

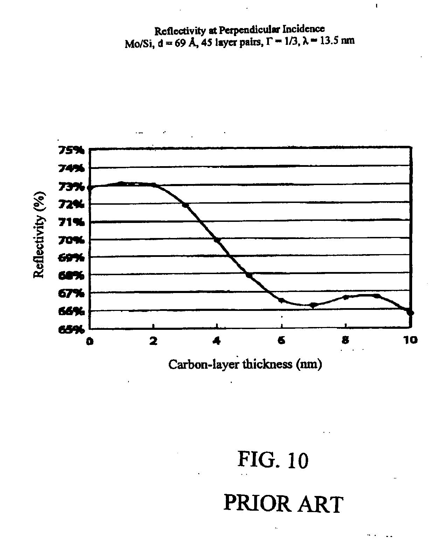

FIG. 10 is a graph showing the effect of the carbon layer on reflectivity of the surface of a multilayer-film mirror. Specifically, the graph illustrates the change in calculated reflectivity resulting from formation of the carbon layer on the surface of a Mo/Si multilayer film. The multilayer film in this example consists of 45 Mo/Si layer pairs having a period thickness ("d") of d = 6.9 nm and a "film-thickness ratio" ("Ã"; ratio of high-Z (Mo) layer thickness to period length) of Ã= 1/3, with Si being the uppermost layer. The surface of the multilayer film is irradiated perpendicularly with EUV light of ë = 13.5 nm. The abscissa in FIG. 10 is carbon-layer thickness (nm) and the ordinate is reflectivity (%). FIG. 10 shows that no decrease in reflectivity is exhibited whenever the thickness of the carbon layer is 2 nm or less. But, as the carbon-layer thickness exceeds 2 nm, reflectivity gradually decreases. At a carbon-layer thickness of 6 nm reflectivity is reduced by at least 6 percent from maximal.

As noted above, a decrease in reflectivity does not occur so long as the thickness of the carbon layer on the surface of the multilayer-film mirror is 2 nm or less. This is because the refractive index of the carbon layer is very nearly equal to the refractive index of the high-Z layer (Mo layer) of the multilayer film. Hence, a thin carbon layer behaves as a high-Z layer of the multilayer film.

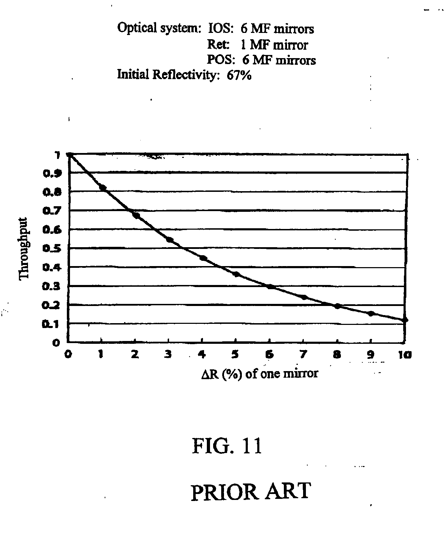

In an EUVL system even a slight decrease in reflectivity of a multilayer-film mirror has a major detrimental impact on the "throughput" of the system (*i.e*., the number of workpieces that can be processed per unit time using the system). FIG. 11 is a graph of throughput (relative to the throughput obtained at maximal reflectivity) as a function of a change in reflectivity (ÄR) of a single multilayer-film mirror of the system. Specifically, the subject system comprises a total of thirteen multilayer-film (MF) mirrors (six in the illumination-optical system (IOS), one constituting the reflective reticle (Ret), and six in the projection-optical system (POS)). FIG. 11 shows the adverse result of a decreased reflectivity of only one multilayer-film mirror on the transmittance of the optical system, wherein throughput is directly proportional to system transmittance. Accompanying a 6-percent decrease in reflectivity of only one multilayer-film mirror, for example, is a system transmittance that is only 30 percent of the maximal value.

A conventional technique for preventing contamination of multilayer-film mirrors and other optical components in an EUVL optical system due to surficial carbon accumulation involves introducing oxygen or water vapor into the atmosphere inside the vacuum chamber enclosing the system, as described in Malinowski *et al., Proceedings SPIE* **4343**:347, 2001. According to this technique, oxygen or water vapor in the chamber is irradiated by the EUV light used for making lithographic exposures, which generates free oxygen radicals. The oxygen free radicals react with the molecules of hydrocarbon-containing gas adsorbed on surfaces of optical elements and also with carbon deposits. These reactions form carbon dioxide gas, which is evacuated from the chamber using a vacuum pump

Unfortunately, the oxygen free radicals generated in the Malinkowski *et al*. method oxidize not only carbon deposits on the surfaces of multilayer-film mirrors, but also the multilayer films themselves. Whenever a multilayer-film is oxidized, the respective surface exhibits a correspondingly decreased reflectivity.

A proposed method for controlling surface oxidation of the multilayer film involves introducing ethanol simultaneously with the oxygen or water vapor. Meiling *et al., Abstracts of the Second International Workshop on EUV Lithography*, San Francisco, CA, p. 17, 2000. This method also utilizes the EUV lithography beam for generating free radicals, and represents an attempt to balance the respective rates of carbon deposition and multilayer-film removal by surface oxidation. Unfortunately, the proposed beneficial effect of the Meiling et al. method is not achievable in actual practice using a working EUVL optical system because EUV-light intensity over the surface of any target multilayer film mirror is not distributed uniformly. As a result, the rate of carbon deposition over the surface is not constant, which makes it very difficult to achieve a balance between the respective rates of carbon deposition and of carbon oxidation at all locations oneach surface.

### Summary

In view of the shortcomings of conventional methods as summarized above, the present invention provides, *inter alia,* multilayer-film reflective optical elements such as mirrors and reticles that exhibit uniformly suppressed accumulation of carbon and other deposits on the reflective surfaces of the elements. Also provided are SXR (EUV) optical systems comprising at least one such optical element, and EUV microlithography systems comprising such optical systems. Also provided are methods for uniformly suppressing the accumulation of carbon and other deposits on the reflective surfaces of the optical elements.

According to a first aspect of the invention, multilayer-film optical elements are provided that are reflective to incident X-radiation. An embodiment of such an optical element comprises a substrate having a reflection surface, a multilayer film formed on the reflection surface, and a protective layer. The multilayer film comprises alternating first and second layers laminated superposedly relative to each other. Each first layer is formed of a first substance exhibiting a relatively large difference between its refractive index for EUV light and a refractive index of a vacuum. Each second layer is formed of a second substance exhibiting a relatively small difference between its refractive index for EUV light and the refractive index in a vacuum. The protective layer is situated superposedly relative to an uppermost layer of the multilayer film, and comprises a photocatalytic material.

The optical element can be configured as, for example, a multilayer-film mirror or a reflective reticle.

The first material also can be designated as a "high-Z" material, and the second material can be designated as a "low-Z" material, as these terms are generally known in the art. Desirably, the uppermost layer of the multilayer film is a layer of the low-Z material.

The protective layer can be formed of a material that includes a photocatalytic material, or the material itself of the layercan be the photocatalytic material. Exemplary photocatalytic materials are one or more of TiO₂, Fe₂O₃, Cu₂O, In₂O₃, WO₃, Fe₂TiO₃, PbO, V₂O₅, FeTiO₃, Bi₂O₃, Nb₂O₃, SrTiO₃, ZnO, BaTiO₃, CaTiO₃, KTiO₃, SnO₂, ZrO₂, and compounds and mixtures thereof. The photocatalytic material exhibits photocatalytic behavior in the presence of light, impinging on the photocatalytic material, typically having a wavelength of 400 nm or less, and desirably having an energy of at least 3 eV. The protective layer desirably has a thickness that is substantially equal to the thickness of a first layer of the multilayer film. Thus, the protective layer exhibits reflective behavior in the same manner as a first layer, and thus imparts no reflectivity decrease to the optical element compared to otherwise similar optical elements that lack a protective layer.

If the optical element is configured as a reflective reticle, the element further can comprise a patterned absorbing-body layer formed superposedly relative to the multilayer film. The absorbing-body layer normally is segmented into individual absorbing bodies distributed over the upper surface of the multilayer film, according to a pattern defined by the reticle. In one configuration a first protective layer is situated between the multilayer film and the patterned absorbing-body layer. This configuration includes a second protective layer, comprising a photocatalytic material, situated superposedly relative to the patterned absorbingbody layer. In another configuration the protective layer is formed so as to cover the absorbing bodies as well as regions of the upper surface of the multilayer film situated between the absorbing bodies.

According to another aspect of the invention, EUV-reflective mirrors are provided. An embodiment of such a mirror comprises a mirror substrate, a multilayer film, and a protective layer. The mirror substrate has a reflection surface on which the multilayer film is formed so as to confer EUV-reflectivity to the mirror. The multilayer film has an upper surface and comprises alternating first and second layers laminated superposedly relative to each other. Each first layer is formed of a high-Z material and each second layer is formed of a low-Z material, wherein the laminated first and secondlayers collectively form an interference coating. The protective layer is formed on the upper surface of the multilayer film and comprises a material exhibiting an ability to photocatalyze, when irradiated by an energizing wavelength of light, moleculesof an oxygen-containing gas so as to form oxygen free radicals. The free radicals are reactive to carbon-containing compounds (e.g., on the surface of the protective layer) contacted by the free radicals. Typical by-products of such reactions are volatile compounds, such as carbon dioxide, that can be removed by vacuum aspiration.

In the multilayer film, the first material can be one or more of Mo, Ru, and Rh, and the second material can be one or more of Si, Be, and B₄C. Mirrors having such a multilayer film are especially reflective to EUV wavelengths.

Desirably, of the multilayer film, the layer actually in contact with the reflection surface of the mirror substrate is a second layer, and the layer actually in contact with the protective layer is a second layer. Also, the protective layer desirably has a thickness equal to a thickness of a first layer. Furthermore, for use with EUV wavelengths, the multilayer film desirably has a period length equal to ë/2, wherein ë is a wavelength of EUV light incident to the mirror.

According to another aspect of the invention, reflective reticles are provided that define a pattern to be transferred from the reticle to a lithographic substrate by EUV lithography. One embodiment of such a reticle comprises a reticle substrate, a multilayer film, a first protective layer, a patterned absorbingbody layer, and a second protective layer. The multilayer film is formed on the reticle substrate so as to confer EUV-reflectivity to the reticle substrate. The multilayer film comprises alternating first and second layers laminated superposedly relative to each other, wherein each first layer is formed of ahigh-Z material and each second layer is formed of a low-Z material. The laminated first and second layers collectively form an interference coating. The first protective layer is formed on the upper surface of the multilayer film, and comprises a mateial exhibiting a photocatalytic ability when irradiated by an energizing wavelength of light. The patterned absorbingbody layer is formed on the first protective layer and is segmented into individual absorbing bodies that, together with spaces between the individual absorbing bodies, define a reticle pattern. The second protective layer is formed on respective upper surfaces of the absorbing bodies and comprises a material exhibiting a photocatalytic ability when irradiated by an energizing wavelength of light.

As noted above, the photocatalytic material(s) exhibits an ability to photocatalyze, when irradiated by the energizing wavelength of light, molecules of an oxygen-containing gas so as to form oxygen free radicals that are reactive to carbon-containing compounds contacted by the free radicals.

Again, it is desirable that the second protective layer comprise a photocatalytic material. A reflective reticle typically is used at an angle of incidence of approximately 2° to 5°. If the absorbing bodies are formed thickly to obtain good contrast between reflective portions and non-reflective portions of the reticle, then the shadows of edges of individual absorbing bodies become too large, which causes the contrast to deteriorate at the edges. Each absorbing body basically is a respective location that does not reflect incident EUV radiation. However, each location at which contamination adheres behaves as if the respective absorbing body has experienced thickening. This causes decreases in pattern contrast at the locations at which contamination has adhered, and can cause "transfer failures." By forming a protective layer at least atop the absorbing bodies, contamination-accumulation on the protective layer is reduced, thereby preventing transfer falures caused by contrast deterioration and extending the useful life of a reflective reticle.

Another embodiment of a reflective reticle comprises a reticle substrate, a multilayer film, an absorbing-body layer, and a protective layer. The multilayer film is formed on the reticle substrate so as to confer EUV-reflectivity to the reticle substrate. The multilayer film comprises alternating first and second layers as summarized above. The absorbing-body layer is formed on the upper surface of the multilayer film and is segmented as summarized above. The protective layer is coated over the absorbing bodies and over the regions of the upper surface situated between the absorbing bodies. As summarized above, the protective layer comprises a material exhibiting a photocatalytic ability. For example, the photocatalytic material exhibits an ability to photocatalyze, when irradiated by the energizing wavelength, molecules of an oxygen-containing gas so as to form oxygen free radicals that are reactive to carbon-containing compounds contacted by the free radicals.

According to another aspect of the invention, X-ray optical systems (e.g., EUV optical systems) are provided that comprise one or more multilayer-film optical elements as summarized above. The subjectoptical elements can be, for example, X-ray-reflective multilayer-film mirrors and/or reflective reticles. The X-ray optical system further can comprise means for directing an energizing wavelength of light to impinge on the multilayer-film optical element. The system further can includes means for introducing an oxygen-containing gas to a vicinity of the multilayer-film optical element. With such a configuration, the photocatalytic material, when illuminated by the energizing wavelength, forms oxygen free radicals from the oxygencontaining gas. The oxygen free radicals are reactive to carbon containing compounds contacted by the free radicals.

According to yet another aspect of the invention, EUV lithography systems are provided. An embodiment of such a system comprises an EUV source, an illumination-optical system, a projection-optical system, and a means for introducing an oxygen-containing gas to a vicinity of the EUV-reflective optical element. The EUV source generates an illumination beam of EUVlight. The illumination-optical system is situated and configured to guide the illumination beam from the EUV source to an EUV-reflective reticle that defines a pattern to be transferred from the reticle to a lithographic substrate. EUV light reflectedfrom the reticle constitutes a patterned beam carrying an aerial image of a region of the reticle illuminated by the illumination beam. The projection-optical system is situated and configured to guide the patterned beam from the reticle to the lithographic substrate, thereby transferring the pattern from the reticle to the substrate. At least one of the illumination-optical system, the reticle, and the projection-optical system includes at least one EUV-reflective optical element as summarized above. With respect to the means for introducing an oxygen-containing gas to the vicinity of the EUV-reflective optical element, the photocatalytic material, when illuminated by an energizing wavelength of light, forms oxygen free radicals from the oxygen containing gas. The oxygen free radicals are reactive to carbon-containing compounds contacted by the free radicals.

At least one of the illumination-optical system and projection-optical system further can comprise means for irradiating light of the energizing wavelength on the at least one EUV-reflective optical element, the energizing wavelength being 400 nm or shorter. The system further can comprise means for irradiating, separately from EUV light passing through the illumination-optical system and projection-optical system, light of the energizing wavelength on at least one EUV-reflective optical element, the energizing wavelength being 400 nm or shorter. In this latter configuration at least the last optical element of the projection-optical system desirably is one of the EUV-reflective optical elements, wherein the means for irradiating is situated so as to irradiate the last optical element with the energizing wavelength.

The projection-optical system typically comprises multiple multilayer-film mirrors each configured as a respective EUV-reflective optical element. The means for irradiating light of the energizing wavelength desirably is situated so as to direct the energizing wavelength on the multilayer-film mirror situated as the last multilayer-film mirror from which the patterned beam reflects to the lithographic substrate.

Also provided are X-ray lithography systems that comprise an X-ray source, configured to produce an illumination beam, and an illumination-optical system. The illumination-optical system is situated and configured to guide the illumination beam from the X-ray source to a selected region on a reflective reticle defining a lithographic pattern to be transferred to a sensitive substrate. The illumination beam reflected from the reticle constitutes a patterned beam carrying an aerial image of the illuminated region. The systems also include a projection-optical system situated and configured to guide the patterned beam from the reticle to the sensitive substrate, so as to transfer the pattern from the reticle to the sensitive substrate. The reflective reticle comprises a reticle substrate, an X-ray-reflective multilayer film formed on the reticle substrate, an absorbing-body layer formed on the upper surface of the multilayer film,and a protective layer. The absorbing-body layer is segmented into individual absorbing bodies separated from one another on the upper surface according to the pattern. The protective layer comprises a photocatalytic material formed on the upper surface of the multilayer film and between the upper surface and the absorbing bodies. The reflective reticle further can comprise a second protective layer as summarized above. The reticle alternatively can comprise a reticle substrate, an X-ray-reflective multilayer film formed on the reticle substrate, an absorbing-body layer formed on the upper surface of the multilayer film, and a protective layer. The absorbing-body layer is segmented as summarized above. The protective layer comprises a photocatalytic material coating the absorbing bodies as well as intervening regions of the upper surface.

Yet another aspect of the invention, set forth in the context of an EUV lithography system that includes an EUV-reflective optical element that includes a multilayer-film interference coating, is directed to methods for preventing accumulation of contaminants on a reflective surface of the optical element. An embodiment of such a method comprises applying a protective layer (comprising a photocatalytic material) to the reflective surface. In the presence of an oxygen containing gas, light of a photocatalytically energizing wavelength is directed to impinge on the protective layer so as to cause the photocatalytic layer to generate oxygen free radicals from the gas. The oxygen free radicals are allowed to react with the contaminants and form volatile byproducts. The method further can comprise the step of removing the volatile byproducts (*e.g.*, by vacuum aspiration). The oxygen-containing gas can be oxygen, watervapor, and/or hydrogen peroxide, or mixtures thereof.

A similar method can be applied to preventing accumulation of contaminants on a reflective reticle used in the EUV lithography system.

The foregoing and additional features and advantages of the invention will be more readily apparent from the following detailed description, which proceeds with reference to the accompanying drawings.

### Brief Description of the Drawings

FIG. 1 is a schematic elevational section of a portion of a multilayer-film reflective optical element, configured as a multilayer-film mirror, according to a first representative embodiment.
FIG. 2 is a graph of reflectivity (at perpendicular incidence) versus wavelength for a multilayer-film mirror including a protective layer (including TiO₂ as a photocatalytic material) and an otherwise similar multilayer-film mirror lacking the protective layer.
FIG. 3 is a schematic optical diagram of a representative embodiment of an X-ray microlithography system comprising at least one multilayer-film reflective optical element according to any of the embodiments described herein.
FIG. 4 provides a detailed view of the projection-optical system of the microlithography system shown in FIG. 3.
FIG. 5 is a schematic elevational section of a multilayer-film reflective optical element, configured as first representative embodiment of a reflective reticle.
FIG. 6 is a schematic elevational section of a multilayer-film reflective optical element, configured as a second representative embodiment of a reflective reticle.
FIGS. 7(a)-7(f) are respective elevational sections schematically depicting the results of respective steps in a representative embodiment of a method for manufacturing the reflective reticle of FIG. 5.
FIGS. 8(a)-8(b) are respective elevational sections schematically depicting the results of respective steps in a representative embodiment of a method for manufacturing the reflective reticle of FIG. 6.
FIG. 9 is a schematic optical diagram of another representative embodiment of an X-ray microlithography system comprising at least one multilayer-film reflective optical element (including a reflective reticle) according to any of the embodiments described herein.
FIG. 10 is a graph of reflectivity versus thickness of a surficial carbon layer on a conventional Mo/Si multilayer-film mirror, assuming perpendicular incidence.
FIG. 11 is a graph of throughput versus change in reflectivity of a single multilayer-film mirror in a conventional X-ray optical system as used in an X-ray microlithography system.

### Detailed Description

The invention is described below in the context of representative embodiments that are not intended to be limiting in any way.

As discussed above, no known materials exhibit an ability to refract soft-X-ray (SXR; also termed "extreme UV" or "EUV") radiation. Consequently, SXR optical systems employ reflective optical elements for bending and converging a beam of SXR light. In the case of an EUV lithography (EUVL) system, the pattern-defining reticle also is reflective and instructurally similar in certain respects to a multilayer-film mirror. As used herein, the term "reflective optical element" used in the context of an SXR or EUV optical system encompasses not only any of various mirrors (*e.g.*, grazing-incidence or multilayer-film) but also reticles.

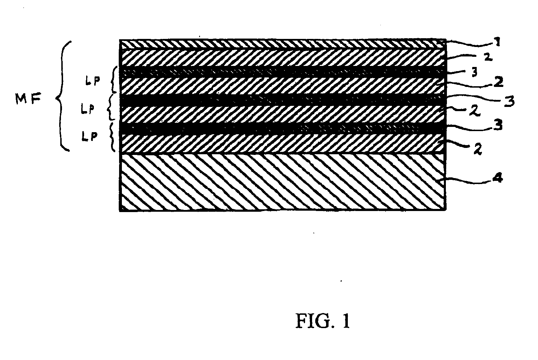

A first representative embodiment of a reflective optical element, configured as a multilayer-film mirror, is shown in FIG. 1. For simplicity the number of laminated layers of the multilayer film MF is depicted as fewer than in a typical multilayer-film mirror. Also, whereas the multilayer-film mirror is depicted for simplicity as a planar mirror, it will be understood that most multilayer-film mirrors have a curved reflective surface. In FIG. 1, the reflective surface faces upward. The depicted multilayer film MF is formed on a mirror substrate 4, and comprises multiple superposed layer-pairs LP each consisting of a respective "high-Z" layer 3 and a respective "low-Z" layer 2. Each high-Z layer 3 is formed of a substance exhibiting a relatively large difference between its refractive index in the SXR region and the refractive index of a vacuum. Each low-Z layer 2 is formed of a substance exhibiting a relatively small difference between its refractive index in the SXR region and the refractive index of a vacuum. In each layer-pair LP the respective high-Z layer 3 and low-Z layer 2 are laminated alternatingly in a superposed manner.

The mirror substrate 4 can be any of various suitable materials (typically glassy materials)that can be worked to extremely high accuracy and precision. Exemplary mirror-substrate materials are ULE®, which is a low-thermal-expansion glass made by Corning, and Zerodur® made by Schott. To prevent decreases in reflectivity of the multilayer-film mirror arising from surface roughness of the "reflection surface" of the mirror substrate (in the figure, the upward-facing surface of the mirror substrate 4), the reflection surface desirably is polished to a surface roughness of 0.3 nm RMS or less.

By way of example, the multilayer film MF is a Mo/Si multilayer film, formed on the reflection surface of the mirror substrate 4 by sputtering. In this configuration (which is suitable for exhibiting high reflection to EUV light of about 13.5 nm) each Mo layer is a respective high-Z layer 3 having a respective thickness of 2.3 nm, and each Si layer is a respective low-Z layer 2 having a respective thickness of 4.6 nm, yielding a "period length" (thickness of one layer pair LP) of d = 6.9 nm.

The low-Z layers 2 and high-Z layers 3 are laminated alternatingly in a superposed manner to form the multilayer film. The first low-Z layer 2 is grown directly on the reflection surface of the mirror substrate 4, and the first high-Z layer 3 is grown on the first low-Z layer 2. This layer-formation scheme is repeated as required to form a multilayer film MF comprising, for example, 46 low-Z layers 2 and 45 high-Z layers 3. Note that the penultimate layer in this example is a low-Z layer 2.

A "protective layer" 1 is formedover the 46th low-Z layer 2. The protective layer 1 is a "photocatalytic layer" formed in this example of titanium oxide (TiO₂), which is a photocatalytic material. The thickness of the protective layer 1 in this example is the same (2.3 nm) as the thickness of the high-Z layer 3. Formation of the protective layer 1 completes formation of the multilayer-film mirror. The protective layer 1 may be formed by sputtering using titanium oxide as the target material, or by sputtering in an argon and oxygen atmosphere with titanium as the target material. Alternatively, the protective layer 1 can be formed of any of various other photocatalytic materials. These alternative photocatalytic materials include, but are not limited to, Fe₂O₃, Cu₂O, In₂O₃, Fe₂TiO₃, PbO, V₂O₅, FeTiO₃, Bi₂O₃, Nb₂O₃, SrTiO₃, ZrO, BaTiO₃, CaTiO₃, KTiO₃, SnO₂, and ZrO₂. The protective layer can be a material that comprises one or more of these photocatalytic materials.

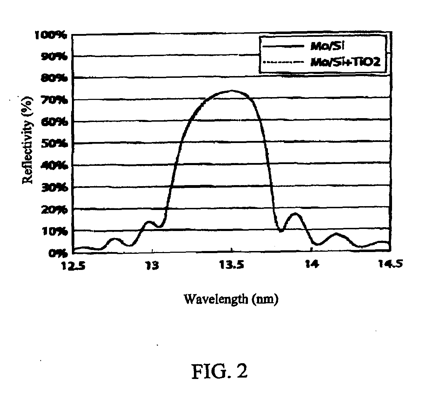

Reflectivity (of perpendicularly incident EUV light of ë = 13.5 nm) from the exemplary multilayer-film mirror of FIG. 1 was measured. As a comparison example, similar reflectivity was measured from an otherwise similar multilayer film mirror lacking the protective layer 1. The relationship between incident wavelength and reflectivity is shown in the graph of FIG. 2, in which the abscissa is wavelength and the ordinate is reflectivity. As shown in FIG. 2, both mirrors exhibit an identical reflectivity profile. Hence, the protective layer 1 does not adversely affect reflectivity of the mirror.

The multilayer-film mirror according to this embodiment was installed in a vacuum chamber in which the mirror was irradiated using a beam of EUV light. As a comparison example, the multilayer-film mirror lacking the protective layer1 was evaluated in a similar manner. The irradiation beam was produced by an EUV-light source producing an EUV beam of ë = 13.5 nm. Under high vacuum the EUV beam was irradiated on each mirror for five hours at an intensity of approximately 1 mW/mm² as a photoresist vapor (an exemplary hydrocarbon-containing gas) was being introduced into the vacuum chamber. The partial pressure of the hydrocarbon containing gas was 1×10⁻⁸ Torr. After completing EUV irradiation under these conditions, the reflectivity of both mirrors was determined. The reflectivity of the multilayer film of the comparison example (lacking the protective layer 1) had decreased by about 10 percent. The multilayer-film mirror of this embodiment exhibited no decrease in reflectivity. Analysis of the respective multilayer-film surfaces of the mirrors by Auger electron spectroscopy revealed a layer of carbon on the multilayer-film surface of the comparison example, and no carbon on the multilayer-film surface of the mirror of this embodiment.

In a similar experiment, each of the multilayer-film mirrors was irradiated with a beam of EUV light under high vacuum while introducing both water vapor and the hydrocarbon-containing gas into the vacuum chamber. The partial pressure of the water vapor was 1×10⁻⁸ Torr and of the hydrocarbon-containing gas was 1×10⁻⁸ Torr. After completing irradiation under these conditions, the reflectivity of both mirrors was determined. The reflectivity of the multilayer film of the comparison example (lacking theprotective layer 1) was decreased by about 5 percent. The multilayer-film mirror of this embodiment exhibited no decrease in reflectivity. Analysis of the respective multilayer-film surfaces of the mirrors by Auger electron spectroscopy revealed an oxidation layer on the uppermost low-Z layer 2 of the multilayer-film surface of the comparison example. No oxidation of the uppermost low-Z layer 2 was found on the multilayer-film mirror of this embodiment.

As an alternative to the multilayer film comprising alternating Mo/Si layers as described above, a multilayer-film mirror according to this embodiment can comprise alternating layers of other materials. For example, a Mo/Be multilayer film exhibits high reflectivity at EUV wavelengths near 11 nm, wherein the Be layers are the low-Z layers 2, and the Mo layers are the high-Z layers 3.

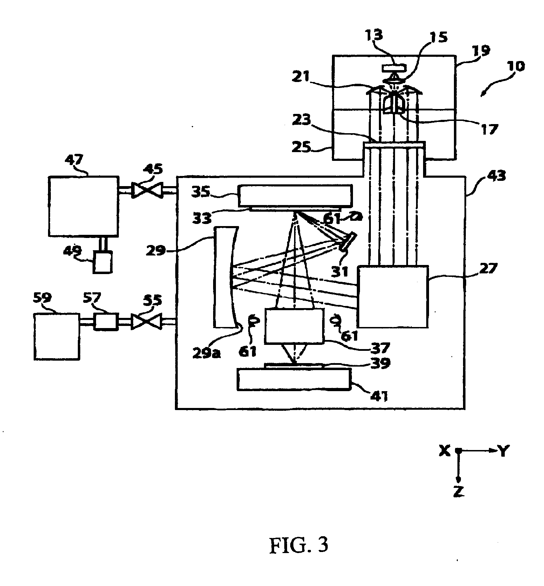

A SXR (EUV) projection-microlithography system 10 including one or more reflective optical components as described above is shown in FIG. 3. The system 10 of FIG. 3 employs, as a lithographic energy beam, a beam of EUV light of ë = 13 nm. The depicted system is configured to perform microlithographic exposures in a step-and-scan manner.

The EUV beam is produced by a laser-plasma source 17 excited by a laser 13 situated at the most upstream end of the depicted system 10. The laser 13 generates laser light at a wavelength within the range of near-infrared to visible. For example, the laser 13 can be a YAG laser or an excimer laser. Laser light emitted from the laser 13 is condensed by a condensing optical system 15 anddirected to the downstream laser-plasma source 17. Upon receiving the laser light, the laser-plasma source 17 generates SXR (EUV) radiation having a wavelength (ë) of approximately 13 nm with good efficiency.

A nozzle (not shown), disposed near the laser-plasma source 17, discharges xenon gas in a manner such that the discharged xenon gas is irradiated with the laser light in the laser-plasma source 17. The laser light heats the discharged xenon gas to a temperature sufficiently high to produce a plasma that emits photons of EUV light as the irradiated xenon atoms transition to a lower-potential state. Since EUV light has low transmittance in air, the optical path for EUV light propagating from the laser-plasma source 17 is contained in a vacuum chamber 19 normally evacuated to high vacuum. Since debris normally is produced in the vicinity of the nozzle discharging xenon gas, the vacuum chamber 19 desirably is separate from other chambers of the system.

A parabolic mirror 21, coated with a Mo/Si multilayer film, is disposed relative to the laser-plasma source 17 so as to receive EUV light radiating from the laser-plasma source 17 and to reflect the EUV light in a downstream direction as a collimated beam. The multilayer film on the parabolic mirror 21 is configured to have high reflectivity for EUV light of which ë = approximately 13 nm.

The collimated beam passes through a visible-light-blocking filter 23 situated downstream of the parabolic mirror 21. By way of example, the filter 23 is made of Be, with a thickness of 0.15 nm. Of the EUV radiation reflected by the parabolic mirror 21, only the desired 13-nm wavelength of radiation passes through the filter 23. The filter 23 is contained in a vacuum chamber 25 evacuated to high vacuum.

An exposure chamber 43 is disposed downstream of the filter23. The exposure chamber 43 contains an illumination-optical system 27 that comprises a condenser mirror and a fly-eye mirror (not shown, but well-understood in the art). The illumination-optical system 27 also is configured to trim the EUV beam (propagating from the filter 23) to have an arc-shaped transverse profile. The shaped "illumination beam" is irradiated toward the left in the figure.

A circular, concave mirror 29 is situated so as to receive the illumination beam from the illuminationoptical system 27. The concave mirror 29 has a parabolic reflective surface 29a and is mounted perpendicularly in the vacuum chamber 43. The concave mirror 29 comprises, for example, a quartz mirror substrate of which the reflection surface is machined extremely accurately to the desired parabolic configuration. The reflection surface of the mirror substrate is coated with a Mo/Si multilayer film so as to form the reflective surface 29a that is highly reflective to EUV radiation of which ë = 13 nm. Alternatively, for other wavelengths in the range of 10-15 nm, the multilayer film can be of a first substance such as Ru (ruthenium) or Rh (rhodium) and a second substance such as Si, Be (beryllium), or B₄C (carbon tetraboride).

A mirror 31 is situated at an angle relative to the concave mirror 29 so as to receive the EUV beam from the concave mirror 29 and direct the beam at a low angle of incidence to a reflective reticle 33. The reticle 33 is disposed horizontally so that its reflective surface faces downward in the figure. Thus, the beam of EUV radiation emitted from the illumination-optical system 27 is reflected and condensed by the concave mirror 29, directed by the mirror 31, and focused on the reflective surface of the reticle 33.

The reticle 33 includes a multilayer film so as to be highly reflective to incident EUV light. A reticle pattern, corresponding to the pattern to be transferred to a substrate 39, is defined in an EUV-absorbing layer formed on the multilayer film of the reticle 33, as discussed later below. The reticle 33 is mounted to a reticle stage 35 that moves the reticle 33 at least in the Y direction. The reticle 33 normally is too large to be illuminated entirely during a single exposure "shot" of the EUV beam. As a result of the movability of the reticle stage 35, successive regions of the reticle 33 can be irradiated sequentially so as to illuminate the pattern in a progressive manner with EUV light from the mirror 31.

A projection-optical system 37 and substrate (*e.g.*, semiconductor wafer) 39 are disposed in that order downstream of the reticle 33. The projection-optical system 37 comprises multiple multilayer-film reflective mirrors that collectively demagnify an aerial image of the illuminated portion of the pattern on the reticle 33. The demagnification normally is according to a predetermined "demagnification factor" *(e.g.,* 1/4). The projection-optical system 37 focuses an aerial image of the illuminated pattern portion onto the surface of the substrate 39. Meanwhile, the substrate 39 is mounted to a substrate stage 41 that is movable in the X, Y, and Z directions.

Connected to the exposure chamber 43 via a gate valve 45 is a preliminary-evacuation ("load-lock") chamber 47. The load-lock chamber 47 allows exchanges of the reticle 33 and/or substrate 39 as required. The load-lock chamber 47 is connected to a vacuum pump 49 that evacuates the load-lock chamber 47 to a vacuum level substantially equal to the vacuum level inside the exposure chamber 43.

During a microlithographic exposure, EUV light from the illumination-optical system 27 irradiates the reflective surface of the reticle 33. Meanwhile, the reticle 33 and substrate 39 are moved by their respective stages 35, 41 in a synchronous manner relative to the projection-optical system 37. The stages 35, 41 move the reticle 33 and substrate 39, respectively, at a velocity ratio determined by the demagnification factor of the projection-optical system 37. Thus, the entire circuit pattern defined on the reticle 33 is transferred, in a step-and-scan manner, to one or more "die" or "chip" locations on the substrate 39. By way of example, each "die" or "chip" on the substrate 39 is a square having 25-mm sides. The pattern is thus "transferred" from the reticle 33 to the substrate at very high resolution (*e.g*., sufficient to resolve a 0.07-ì m line-and-space (L/S) pattern). So as to be imprintable with the projected pattern, the upstream-facing surface of the substrate 39 is coated with a suitable "resist."

In the system 10 of FIG. 3 at least one multilayer-film optical element as described above is included in at least one of the illumination-optical system 27, the reticle 33, and the projection-optical system 37.

The system 10 also comprises a means for introducing an oxygen-containing gas into the exposure chamber 43 in the vicinity of the multilayer-film mirror(s) as EUV radiation is impinging on the multilayer-film mirror(s). As shown in FIG. 3, the oxygen-containing gas is supplied from gas reservoir 59, from which the gas is introduced into the exposure chamber 43 via a flow-control meter 57 and valve 55.

Inside the exposure chamber 43 and situated adjacent the multilayer-film mirror(s) are one or more lamps 61 that produce a catalysis-"energizing" light having a wavelength of 400 nm or less and an energylevel of, desirably, 3 eV or greater. For example, the light produced by the lamps 61 can be visible light, ultraviolet light, or EUV light. Light from a lamp 61 is directed so as to irradiate a reflective surface of at least one multilayer-film mirror, and serves to accelerate the photocatalytic reaction occurring on and in the respective protective layer(s).

It will be understood that the lamp(s) 61 are not necessary. Catalysis can be energized sufficiently in many instances using light normally used of performing microlithography. For example, the energizing light can be supplied by an EUV light source such as the laser-plasma source 17. Alternatively or in addition, one or more lamps 61 can be used. If lamps 61 are employed, a respective lamp 61 need not be provided for each multilayer-film mirror in the system. Rather, certain multilayer-film mirror(s) can be selected for enhanced irradiation by the energizing wavelength, using a respective lamp(s). Thus, using the lamp(s) 61, the removal of hydrocarbon molecules adsorbed onto the protective layer(s) can be enhanced relative to a situation in which lamp(s) 61 are not used. In other words, a lamp 61 desirably is used to increase the amount of energizing wavelength impinging on the subject multilayer-film mirror, relative to the amount of light normally impinging on the mirror from the laser-plasma source 17.

If a sufficient amount of the oxygen-containing gas is provided to the location being irradiated by the energizing wavelength, then the photocatalysis reactions (having rates that are proportional to the intensity of the energizing wavelength of light) progress rapidly. Even there is an uneven distribution of the intensity of energizingwavelength light on the surface of a multilayer-film minor, contaminant (*e.g.*, carbon) removal progresses rapidly at locations at which the rate of contaminant deposition is rapid. Contaminant removal is slower at locations at which the contaminant-deposition rate is relatively slow. Thus, it is possible to prevent contaminant deposition and to facilitate contaminant removal across the entire reflective surface of the mirror.

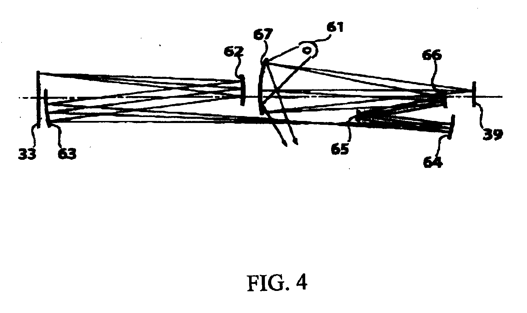

The projection-optical system 37 normally comprises multiple multilayer film mirrors. An especially advantageous use of lamp(s) 61 is in association with the multilayer-film mirror situated closest to the substrate 39. FIG. 4 depicts certain details of an exemplary projection-optical system 37 that comprises six multilayer-film mirrors 62, 63, 64, 65, 66, 67. The beam of EUV light reflected from the reticle 33 is reflected by the multilayer-film mirrors 62, 63, 64, 65, 66, 67 in that order. From the "last" mirror 67 the EUV light reaches the substrate 39 and forms an image of the illuminated reticle pattern on the substrate 39. In the projection-optical system of FIG. 4 a lamp 61 is provided near the multilayer film mirror 67 (situated closest to the substrate 39 and thus is the last mirror to reflect EUV light). The lamp 61 is arranged such that light from it (having a wavelength of 400 nm or less) irradiates the reflective surface of the multilayer-film mirror 67. The lamp 61 is provided because: (1) the reflective surface of the multilayer-film mirror 67 faces the substrate; (2) the mirror 67 is the last mirror that reflects the EUV lithography beam, and so the intensity of the EUV lithography beam is lowest at the mirror 67; and (3) due to (1) and (2), it is difficult to remove contamination from the mirror 67 using only the EUV light beam. The lamp 61 is situated such that light herefrom does not reflect toward the substrate 39.

As the mirror 67 is being irradiated by light from the lamp 61, an "oxygen containing gas" (*e.g.*, a gas comprising one or more of oxygen, water vapor, and hydrogen peroxide) is introduced into the exposure chamber 43 from the reservoir 59 via the flow controller 57 and valve 55. The partial pressure of this gas in the exposure chamber 43 is, for example, 1×10⁻⁸ Torr.

In a comparison example a multilayer-film mirror lacking the protective layer 1 was used as the multilayer-film mirror 67 in the system of FIG. 3. After 100 hours of use under actual exposure conditions, the surface of the comparison-example mirror 67 had become oxidized significantly. The oxidation caused the projection-optical system 37 (comprising the mirror 67) to exhibit a decrease in reflectivity of sufficient magnitude to reduce the amount of EUV light reaching the substrate 39 to approximately half its initial intensity (at the beginning of the 100 hour period). In contrast, in an evaluation example the multilayer-film mirror 67 included a protective layer, as described above. After 100 hours' use under actual exposure conditions, no decrease in the amount of light reaching the substrate 39 was observed, indicating that the evaluation-example mirror 67 remained free of surficial oxidation.

As described above, a multilayer-film mirror is provided with a protective layer formed of a photocatalytic material. The protective layer is the uppermost layer of the multilayer film. By introducing an oxygen-containing gas *(e.g.,* oxygen gas, water vapor, or hydrogen peroxide) into the atmosphere surrounding the mirror and irradiating the protective surface with light having a wavelength of 400 nm or less, the gas produces oxygen radicals by a photocatalytic reaction involving the photocatalytic material in the protective layer. Hydrocarbon molecules adsorbed on the protective layer react with the oxygen radicals and produce carbon dioxide gas, which is evacuated readily using a vacuum pump.

As noted above, multilayer-film reflective optical elements according to an aspect of the invention are not limited to multilayer-film mirrors. Another example of a multilayer-film reflective optical element is a reflective reticle as used *,e.g*., for defining a pattern used in EUV projection microlithography.

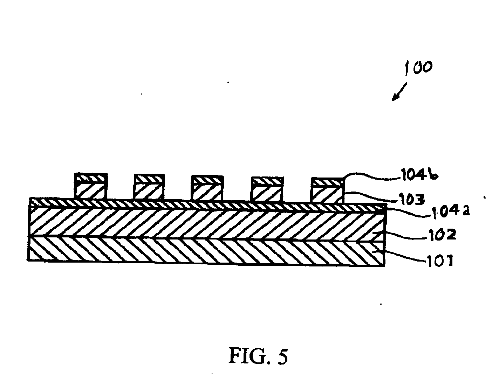

A portion of a representative embodiment of a reflective reticle 100 is shown schematically in FIG. 5. The reticle 100 includes a reticle substrate 101 (made, *e.g*., of silicon), and a multilayer film102 formed on the reticle substrate 101. The multilayer film 102 comprises, as discussed generally above, alternating layers of different materials that collectively confer high reflectivity of the reticle 100 to incident X-radiation *(e.g.,* SXR or EUV radiation) and provide the pattern defined by the reticle with high contrast. Exemplary multilayer films are Mo/Si, Ru/Si, Mo compound/Si, Ru compound/Si, Mo/Si compound, Ru/Si compound, Mo compound/Si compound, and Ru compound/Si compound. Any of these multilayer films exhibits high reflectivity to incident EUV radiation having a wavelength in the vicinity of the 13-nm wavelength used in EUV microlithography. The reticle substrate 101 can be made of any material that satisfies prevailing criteria for surface roughness and planarity. Exemplary materials are glass and metal.

The reticle also includes portions of an "absorbingbody layer" 103 formed on the multilayer film 102. The absorbing body layer 103 comprises a substance having a low transmittance (*i.e*., a high absorption coefficient) for incident reticle illumination radiation. For example, the absorbing-body layer 103 is made of a material that absorbs (*i.e*., has a high absorption coefficient for) incident EUV radiation. The absorbing-body layer 103 is formed as a contiguous layer that subsequently is *"micromachined" (i.e.,* lithographically patterned and etched) so as to define the elements of the desired pattern. *I.e.,* after micromachining, the elements (and intervening spaces) are defined by theremaining portions of the absorbing-body layer 103, termed "absorbing bodies" and spaces separating the absorbing bodies from one another.

At the edges of the absorbing bodies, to minimize any decrease in pattern contrast caused by grazing-incidence illumination light, it is desirable that the absorbing-body layer 103 be formed as thinly as possible. Exemplary materials useful for an incident wavelength of approximately 13 nm include Ag, Al, Au, Cd, Co, Cu, Fe, Cr, Ge, In, Ir, Mn, Ni, Os, Pb, Pd, Pt, Re, Te, Ta, Sn, Zn, and compounds and mixtures thereof. These materials have high respective absorption coefficients for EUV light and can be made very thin.

The reticle also includes at least one protective layer 104 that comprises a photocatalytic material For example, the reticle of FIG. 5 includes one protective layer 104a formed between the absorbingbody layer 103 and the multilayer film 102. Another protective layer 104b is formed atop the absorbing-body layer 103. (Thus, patterning the absorbing-body layer 103 results in patterning of the protective layer 104b.) Each protective layer 104a, 104b can comprise any of various materials that exhibit photocatalytic behavior, such as (but not limited to): TiO₂, Fe₂O₃, Cu₂O, In₂O₃, WO₃, Fe₂TiO₃, PbO, V₂O₅, FeTiO₃, Bi₂O₃, Nb₂O₃, SrTiO₃, ZnO, BaTiO₃, CaTiO₃, KTaO₃, SnO₂, ZrO₂.

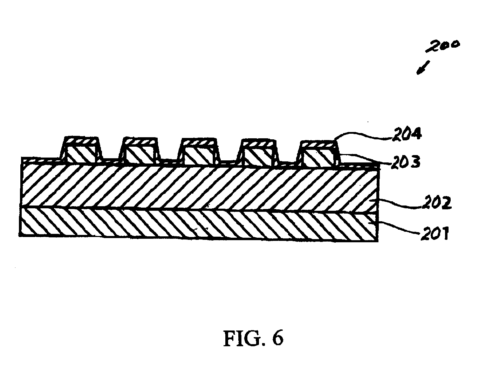

Another embodiment of a reflective reticle 200 is depicted in FIG. 6. The reticle 200 comprises a reticle substrate 201 made, *e.g.,* of silicon. An X-ray-reflective multilayer film 202 is formed on the reticle substrate 201. The material forming the multilayer film 2 can be the same as used to form the multilayer film 102 in the embodiment of FIG. 5. The reticle 200 also comprises an absorbingbody layer 203 formed on the surface of the multilayer film 202 and micromachined to define individual elements of the pattern. The material used to form the absorbing body layer 203 can be any of the materials used to form the corresponding layer in the embodiment of FIG. 5. The reticle substrate 201 can be formed of any suitable material that satisfies applicable criteria for surface roughness and planarity (*e.g*., glass or metal).

The reticle 200 also includes a protective layer 204, comprising a photocatalytic material, covering the multilayer film 202 and remaining portions of the absorbing-body layer 203. *I.e*., the protective layer 204 covers the "top" and "side" surfaces of individual absorbing bodies, as well as the "top" surface of intervening regions of the multilayer film 202. In this embodiment the protective layer 204 does not extend "beneath" the absorbing bodies between the absorbing body layer 203 and the multilayer film 202. The protective layer 204 comprises a photocatalytic material, as described in connection with the embodiment of FIG. 5.

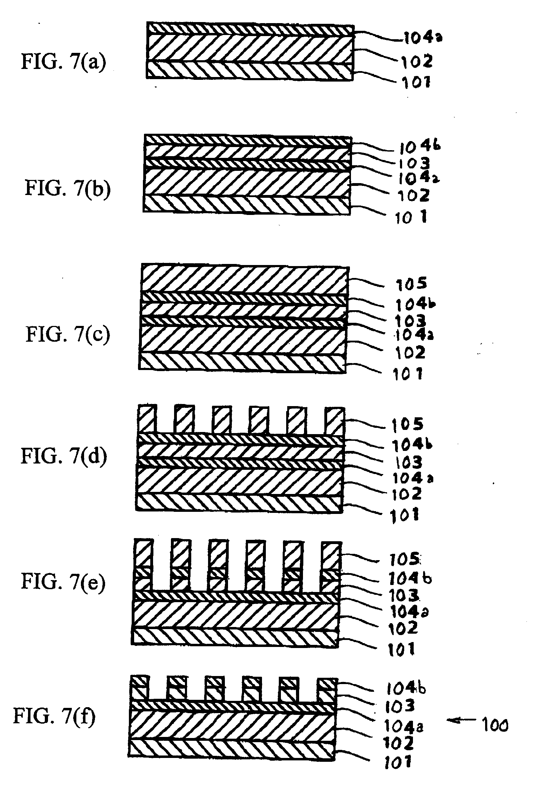

The reticle of FIG. 5 can be manufactured using a method as shown in FIGS. 7(a)-7(f), in which the results of specific respective steps are illustrated. In the first step, a Mo/Si multilayer film 102 and a first protective layer 104a comprising a photocatalytic material are formed by ion-beam sputtering (IBS) on a silicon reticle substrate 101 (see FIG. 7(a)). Next, a Ta layer (destined to be the absorbing-body layer 103) is formed on the first protective layer 104a, and a TiO₂ layer (destined to be the second protective layer 104b (see FIG. 7(b)) is formed on the absorbing-body layer 103. A positive electron-beam resist 105 is applied over the second protective layer 104b (see FIG. 7(c)). The resist 105 is patterned lithographically aid developed by electron-beam microlithography (see FIG. 7(d)) according to the pattern to be defined by the reticle. Using the patterned resist 105 as a mask, the second protective layer 104b and underlying absorbingbody layer 103 are patterned by dry etching (see FIG. 7(e)). The resist 105 is removed and the surface of the reticle is cleaned, yielding a patterned reflective reticle 100 in which pattern elements are defined by respective units of the second protective layer 104b and the absorbing-body layer 103 (FIG. 7(f)).

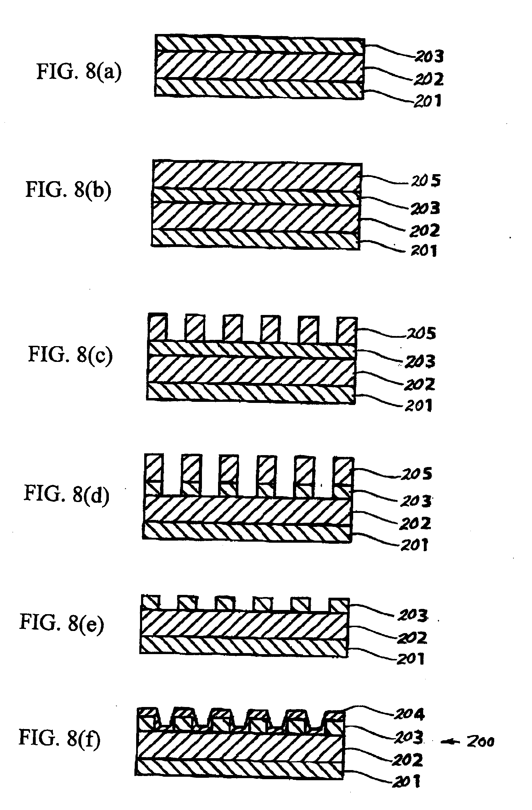

The reticle embodiment of FIG. 6 can be manufactured using a method as shown in FIGS. 8(a)-8(f). In a first step, a Mo/Si multilayer film 202 and a protective layer 204 comprising a photocatalytic material are formed on a silicon reticle substrate 201 by IBS (see FIG. 8(a)). Next, an electron-beam positive resist 205 is applied (FIG. 8(b)) and microlithographically exposed using an electron-beam microlithography system (see FIG. 8(c)). Using the patterned resist 205 as a mask, the absorbing-body layer 203 is patterned by dry-etching (FIG. 8(d)). Residual resist is removed and the surface of the reticle is cleaned, yielding a patterned reflective reticle 200 in which pattern elements are defined by respective units of the absorbing-body layer 203 (FIG. 8(e)). After confirming the absence of any reticle defects, the protective layer 204 is formed on the surface of the reticle (FIG. 8(f)).

The following working examples are provided for a more complete disclosure, but the working examples are not intended to be limiting in any way.

### Working Example 1

In this example the reflective reticle 100 shown in FIG. 5 was manufactured according to the manufacturing steps shown in FIGS. 7(a)-7(f). First, the multilayer film 102 was formed by IBS on the surface of a silicon reticle substrate 101. The reticle substrate 101 was 100 mm wide, 100 mm long, and 5 mm thick. The multilayer film 102, consisting of 40 pairs of alternating layers of Mo and Si, with a period length d = 6.9 nm and a film-thickness ratio Ã= 0.35, was formed on the first protective layer 104a. Then, the first protective layer 104a (TiO₂) was formed by IBS on the surface of the multilayer film 102 (see FIG. 7(a)). The thickness of the first protective layer 104a was 2 nm. Then, the absorbing-body layer 103, made of Ta with a thickness of 50 nm, was formed on the first protective layer 104a. The second protective layer 104b (TiO₂) was grown on the absorbing-body layer 103 to a thickness of 7 nm (see FIG. 7(b)). An electron-beam positive resist 105 was applied at a thickness of 1 ì m to the second protective layer 104b (see FIG. 7(c)). The resist 105 was patterned with the desired reticle pattern (having L&S dimensions of 0.25 to 1 ì m) using an electron-beam microlithography system and developed (see FIG. 7(d)). After development, the resist pattern was used as a mask for selectively patterning the second protective layer 104b and the absorbing-body layer 103 by dry-etching (see FIG. 7(e)). The resist 105 was removed and the reticle surface was cleaned, yielding a reflective reticle 100 having a patterned second protective layer 104b and absorbing-body layer 103 (see FIG. 7(f)).

The reflectivity of the multilayer film 102 of the reticle 100 was about 65 %, which is the same as the reflectivity (about 65 %) of an otherwise similar multilayer film *(e.g.,* on a multilayer-film mirror) lacking the protective layers 104a, 104b. The reflectivity of the absorbingbody layer 103 was about 0.6 %, yielding a pattern contrast of (65/0.6) 110. The reticle 100 also exhibited a good ability (when irradiated with ultraviolet radiation in the presence of an oxygen-containing gas) to remove carbon contamination intentionally adhered to the surface of the reticle 100.

### Working Example 2

In this example the reflective reticle 200 shown in FIG. 6 was manufactured according to the manufacturing steps shown in FIGS. 8(a)-8(f). First, the multilayer film 202 and absorbingbody layer 203 were formed by IBS on the surface of a silicon reticle substrate 201. The reticle substrate 201 was 100 mm wide, 100 mm long, and 5 mm thick (see FIG. 8(a)). The multilayer film 202, consisting of 40 pairs of alternating layers of Mo and Si, with a period length d = 6.9 nm and a film thickness ratio Ã= 0.35, was formed on the reticle substrate 201. The absorbing-body layer 203, made of Ta with a thickness of 70 nm, was formed on the multilayer film 202. An electron-beam positive resist 205 was applied at a thickness of 1 ì m to the absorbing-body layer 203 (see FIG. 7(b)). The resist 205 was patterned with the desired reticle pattern (having L&S dimensions of 0.25 to 1 ì m) using an electron-beam microlithography system and developed (see FIG. 8(c)). After development, the patterned resist 205 was used as a mask for patterning the absorbing-body layer 203 by dry-etching (see FIG. 8(d)). The resist 205 was removed and the reticle surface was cleaned, yielding a reflective reticle 200 having a patterned absorbing body layer 203 (see FIG. 8(e)). After confirming the absence of defects in the reticle, the protective layer 204 (TiO₂) was grown to a thickness of 2 nm (see FIG. 8(f)).

The reflectivity of the multilayer film 202 of the reticle 200 was about 65 %, which is the same as the reflectivity (about 65 %) of an otherwise similar multilayer film *(e.g.,* on a multilayer-film mirror) lacking the protective layer 204. The reflectivity of the absorbingbody layer was about 0.6 %, yielding a pattern contrast of (65/0.6) 110. The reticle 200 also exhibited a good ability (when irradiated with ultraviolet radiation in the presence of an oxygen-containing gas) to remove carbon contamination intentionally adhered to the surface of the reticle 200.

### Working Example 3

The reflective reticle of this example was as in Working Example 1, except that the multilayer film102 comprised alternating superposed layers of Mo+Ru and Si. The multilayer film had a film-thickness ratio Ã= 0.35. The absorbing-body layer 103 was a layer of Cr, and ZnO was used as the photocatalytic material in the second protective layer 104b on the absorbing-body layer 103. The thickness of the second protective layer 104 was 7 nm.

The reflectivity of the multilayer film 102 of the reticle 100 was about 66 %, which is the same as the reflectivity (about 66 %) of an otherwise similar multilayer film *(e.g.,* on a multilayer-film mirror) lacking the protective layer 104. The reflectivity of the absorbingbody layer 103 was about 0.4 %, yielding a pattern contrast of (66/0.4) 160. The reticle 100 also exhibited a good ability (when irradiated with ultraviolet radiation in the presence of an oxygencontaining gas) to remove carbon contamination intentionally adhered to the surface of the reticle 100.

### Working Example 4

The reflective reticle of this example was as in Working Example 1, except that the multilayer film 102 comprised alternating superposed layers of Mo+Ru and Si. The multilayer film had a film-thickness ratio Ã= 0.35. The absorbing-body layer 103 was a layer of Cr, and ZnO is used as the photocatalytic material in the second protective layer 104b on the absorbing-body layer 103. The thickness of the second protective layer 104 was 2 nm.

The reflectivity of the multilayer flm 102 of the reticle 100 was about 65 %, which is the same as the reflectivity (about 65 %) of an otherwise similar multilayer film *(e.g.,* on a multilayer-film mirror) lacking the protective layer 104. The reflectivity of the absorbingbody layer 103 was about 0.5 %, yielding a pattern contrast of (65/0.5) 130. The reticle 100 also exhibited a good ability (when irradiated with ultraviolet radiation in the presence of an oxygencontaining gas) to remove carbon contamination intentionally adhered to the surface of the reticle 100.

### Working Example 5

The reflective reticle of this example was as in Working Example 1, except that the photocatalytic material in the second protective layer 104b was SnO₂. The thickness of the second protective layer 104b was 7 nm.

The reflectivity of the multilayer film 102 of the reticle 100 was about 66 %, which is the same as the reflectivity (about 66 %) of an otherwise similar multilayer film *(e.g.,* on a multilayer-film mirror) lacking the protective layer 104. The reflectivity of the absorbing-body layer 103 was about 0.2 %, yielding a pattern contrast of (66/0.2) 330. The reticle 100 also exhibited a good ability (when irradiated with ultraviolet radiation in the presence of an oxygen-containing gas) to remove carbon contamination intentionally adhered to the surface of the reticle 100.

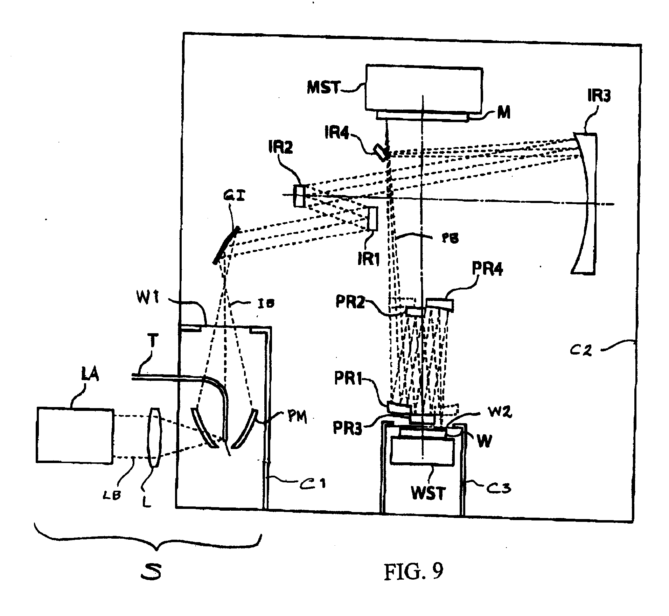

Another embodiment of an X-ray (specifically EUV) microlithography system utilizing one or more multilayer-film reflective optical elements as described herein is shown in FIG. 9. The depicted system comprises the EUV source S, an illumination-optical system (comprising elements GI and IR1-IR4), a reticle stage MST for holding a reflective reticle M, a projection-optical system (comprising elements PR1-PR4) and a substrate stage WST for holding a substrate W *(e.g.,* semiconductor wafer).

The EUV source S generates an illumination beam IB of EUV light. To such end, a laser LA generates and directs a high-intensity laser beam LB (near-IR to visible) through a lens L to the dischargeregion of a nozzle T that discharges a target substance *(e.g.,* xenon). The irradiated target substance forms a plasma that emits photons of EUV light that constitute the illumination beam IB. The illumination beam IB is reflected by a parabolic multilayer-film mirror PM to a window W1. The EUV source S is contained in a chamber C1 that is evacuated to a suitably high vacuum by a vacuum pump (not shown). The illumination beam IB passes through the window W1 to the interior of an optical-system chamber C2.

The illumination beam IB then propagates to the illumination-optical system comprising mirrors GI, IR1, IR2, IR3, IR4. The mirror GI is a grazing-incidence mirror that reflects the grazing-incident illumination beam IB from the EUV source S. (Alternatively, the mirror GI can be a multilayer-film mirror.) The mirrors IR1, IR2, IR3, IR4 are each multilayer-film mirrors each including a surficial multilayer film exhibiting high reflectivity to incident EUV radiation, as described elsewhere herein. The illumination-optical system also comprises a filter (not shown) that is transmissive only to EUV radiation of a prescribed wavelength. The illumination optical system directs the illumination beam IB, having the desired wavelength, to a selected region on the reticle M. The reticle M is a reflective reticle including a multilayer film and protective layer, as described elsewhere herein. The beam reflected from the reticle M carries an aerial image of the illuminated region of the reticle M; hence, the reflected beam is termed a "patterned beam."

The projection-optical system comprises multiple multilayer-film mirrors PR1, PR2, PR3, PR4 that collectively project an image of the illuminated portion of the reticle M onto a corresponding location on the substrate W. Thus, the pattern defined by the reticle M is transfer-exposed onto the substrate W. Note that several of the mirrors PR1-PR4 (specifically the mirrors PR1 and PR4) have a cutout allowing the patterned beam unobstructed passage in the projection-optical system.

So as to be imprintable with the projected pattern, the substrate W is coated with an exposure-sensitive resist. Since EUV radiation is absorbed and attenuated in the atmosphere, the environment in the optical-system chamber C2 is maintained at a suitably high vacuum (*e.g*., 10⁻⁵ Torr or less). Actual exposure of the substrate W can be performed in a "step-and-repeat," "step-and-scan," or purely scanning-exposure manner, or other suitable manner, all of which involving controlled movements of the reticle stage MST and substrate stage WST relative to each other as transfer-exposure of the pattern progresses. During exposure, the substrate W is situated in a separate chamber C3, termed a "substrate chamber" or "wafer chamber," that contains the substrate stage WST. As the patterned beam PB enters the substrate chamber C3 from the optical-system chamber C2, the beam passes through a window W2.

As noted above, the reticle M (as well as any of the multilayer-film mirrors) of the system of FIG. 9 includes a protective layer (that includes a photocatalytic material) formed over at least a portion of the multilayer film. As visible, ultraviolet, or EUV light (from the illumination beam IB or from a separate source; see FIG. 3) irradiates the reticle M in the presence of an oxygen-containing gas, any carbon contamination adhering to the surface of the multilayer film is decomposed. Thus, the rate and extent of reticle contamination can be reduced substantially compared to conventional systems, thereby reducing pattern-transfer failure and contrast degradation, as well as extending the useful life of the reticle.

The reticle used in the system of FIG. 9 can be configured, for example, as shown in FIG. 5 or FIG. 6. In either configuration the surface of the multilayer film at locations not occupied by absorbing bodies is covered by a protective layer. As visible, ultraviolet, or EUV light irradiates such a reticle in the presence of an oxygen-containing gas, any carbon contamination adhering to the surface of the multilayer film is decomposed by photocatalysis. If the reticle is configured as shown in FIG. 6, overall reticle contamination is reduced because the protective layer performs photocatalysis over the entire surface of the reticle.

Whereas the invention has been described in connection with multiple representative embodiments and examples, the invention is not limited to those embodiments and examples. On the contrary, the invention is intended to encompass all modifications, alternatives, and equivalents as may be included within the spirit and scope of the invention, as defined by the appended claims.

## Claims

1. A multilayer-film optical element that is reflective to incident X radiation, the optical element comprising:
a substrate having a reflection surface;
a multilayer film formed on the reflection surface, the multilayer film comprising alternating first and second layers laminated superposedly relative to each other, each first layer being formed of a first substance exhibiting a relatively large difference between its refractive index for EUV light and a refractive index of a vacuum, and each second layer being formed of a second substance exhibiting a relatively small difference between its refractive index for EUV light and the refractive index in a vacuum; and
a protective layer situated superposedly relative to an uppermost layer of the multilayer film, the protective layer comprising a photocatalytic material.

2. The optical element of claim 1, configured as a multilayer-film mirror.

3. The optical element of claim 1, wherein the first material is a high-Z material, and the second material is a low-Z material.

4. The optical element of claim 3, wherein the uppermost layer of the multilayer film is a layer of he low-Z material.

5. The optical element of claim 1, wherein the protective layer consists of a photocatalytic material.

6. The optical element of claim 1, wherein the photocatalytic material is selected from the group consisting of TiO₂, Fe₂O₃, Cu₂O, In₂O₃, WO₃, Fe₂TiO₃, PbO, V₂O₅, FeTiO₃, Bi₂O₃, Nb₂O₃, SrTiO₃, ZnO, BaTiO₃, CaTiO₃, KTiO₃, SnO₂, ZrO₂, and compounds and mixtures thereof.

7. The optical element of claim 1, wherein the photocatalytic material exhibits photocatalytic behavior in the presence of light, impinging on the photocatalytic material, having a wavelength of 400 nm or less.

8. The optical element of claim 1, wherein:
each first layer has a respective thickness; and
the protective layer has a thickness that is substantially equalto the thickness of a first layer.

9. The optical element of claim 1, configured as a reflective reticle.

10. The optical element of claim 9, further comprising a patterned absorbing-body layer formed superposedly relative to the multilayer film, the absorbing-body layer being segmented into individual absorbing bodies distributed over the upper surface of the multilayer film, according to a pattern defined by the reticle.

11. The optical element of claim 10, wherein a first protective layer is situated between the multilayer film and the patterned absorbing-body layer.

12. The optical element of claim 11, further comprising a second protective layer, comprising a photocatalytic material, situated superposedly relative to the patterned absorbing-body layer.

13. The optical element of claim 10, wherein the protective layer is formed so as to cover the absorbing bodies as well as regions of the upper surface of the multilayer film situated between the absorbing bodies.

14. An EUV-reflective mirror, comprising:
a mirror substrate having a reflection surface;
a multilayer film formed on the reflection surface so as to confer EUV-reflectivity to the mirror, the multilayer film having an upper surface and comprising alternating first and second layes laminated superposedly relative to each other, each first layer being formed of a high-Z material and each second layer being formed of a low-Z material, wherein the laminated first and second layers collectively form an interference coating; and
a protective layer formed on the upper surface of the multilayer film, the protective layer comprising a material exhibiting an ability to photocatalyze, when irradiated by an energizing wavelength of light, molecules of an oxygen-containing gas so as to form oxygen free radicals that are reactive to carbon-containing compounds contacted by the free radicals.

15. The mirror of claim 14, wherein the oxygen free radicals are reactive to carbon-containing compounds attached to the protective layer.

16. The mirror of claim 15, wherein the oxygen free radicals react with the carbon-containing compounds to form carbon dioxide from the compounds.

17. The mirror of claim 14, wherein the photocatalytic material is selected from the group consisting of TiO₂, Fe₂O₃, Cu₂O, In₂O₃, WO₃, Fe₂TiO₃, PbO, V₂O₅, FeTiO₃, Bi₂O₃, Nb₂O₃, SrTiO₃, ZnO, BaTiO₃, CaTiO₃, KTiO₃, SnO₂, ZrO₂, and compounds and mixtures thereof.

18. The mirror of claim 14, wherein the photocatalytic material exhibits photocatalytic behavior in the presenceof light, impinging on the photocatalytic material, having a wavelength of 400 nm or less.

19. The mirror of claim 14, wherein the first material is one or more of Mo, Ru, and Rh, and the second material is one or more of Si, Be, and B₄C.

20. The mirror of claim 14, wherein, of the multilayer film, the layer actually in contact with the reflection surface of the mirror substrate is a second layer, and the layer actually in contact with the protective layer is a second layer.

21. The mirror of claim 14, wherein the protective layer has a thickness equal to a thickness of a first layer.

22. The mirror of claim 14, wherein the multilayer film has a period length equal to ë/2, wherein ë is a wavelength of EUV light incident to the mirror.

23. A reflective reticle defining a pattern to be transferred from the reticle to a lithographic substrate by EUV lithography, the reticle comprising:
a reticle substrate;
a multilayer film formed on the reticle substrate so as to confer EUV-reflectivity to the reticle substrate, the multilayer film having an upper surface and comprising alternating firs and second layers laminated superposedly relative to each other, each first layer being formed of a high-Z material and each second layer being formed of a low-Z material, wherein the laminated first and second layers collectively form an interference coating;
a first protective layer formed on the upper surface of the multilayer film, the first protective layer comprising a material exhibiting a photocatalytic ability when irradiated by an energizing wavelength of light;
a patterned absorbing-body layer formed on the first protective layer, the absorbing-body layer being segmented into individual absorbing bodies that, together with spaces between the individual absorbing bodies, define a reticle pattern; and
a second protective layer formed on respective upper surfaces of the absorbing bodies, the second protective layer comprising a material exhibiting a photocatalytic ability when irradiated by an energizing wavelength of light.

24. The reticle of claim 23, wherein the photocatalytic material exhibits an ability to photocatalyze, when irradiated by the energizing wavelength of light, molecules of an oxygen-containing gas so as to form oxygen free radicals that are reactive to carbon-containing compounds contacted by the free radicals.

25. The reticle of claim 23, wherein the photocatalytic material, when illuminated by the energizing wavelength, forms oxygen free radicals from molecules of an oxygen-containing gas in the vicinity of the reticle, the oxygen free radicals being reactive to carbon-containing compounds contacted by the free radicals.

26. The reticle of claim 23, wherein each photocatalytic material is independently selected from the group consisting of TiO₂, Fe₂O₃, Cu₂O, In₂O₃, WO₃, Fe₂TiO₃, PbO, V₂O₅, FeTiO₃, Bi₂O₃, Nb₂O₃, SrTiO₃, ZnO, BaTiO₃, CaTiO₃, KTiO₃, SnO₂, ZrO₂, and compounds and mixtures thereof.

27. The reticle of claim 23, wherein the energizing wavelength is 400 nm or less.

28. A reflective reticle defining a pattern to be transferred from the reticle to a lithographic substrate by EUV lithography, the reticle comprising:
a reticle substrate;
a multilayer film formed on the reticle substrate so as to confer EUV reflectivity to the reticle substrate, the multilayer film having an upper surface and comprising alternating first and second layers laminated superposedly relative to each other, each first layer being formed of a high-Z material and each second layer being formed of a low-Z material, wherein the laminated first and second layers collectively form an interferencecoating;
an absorbing-body layer formed on the upper surface of the multilayer film, the absorbing-body layer being segmented into individual absorbing bodies that, together with areas of the upper surface located between the individual absorbing bodies, define a reticle pattern; and
a protective layer coated over the absorbing bodies and over the regions of the upper surface situated between the absorbing bodies, the protective layer comprising a material exhibiting a photocatalytic ability when irradiated by an energizing wavelength of light.

29. The reticle of claim 28, wherein the photocatalytic material exhibits an ability to photocatalyze, when irradiated by the energizing wavelength, molecules of an oxygen-containing gas so as to form oxygen free radicals that are reactive to carbon-containing compounds contacted by the free radicals.

30. The reticle of claim 28, wherein the photocatalytic material, when illuminated by the energizing wavelength, forms oxygen free radicals from molecules of an oxygen-containing gas in the vicinity of the reticle, the oxygen free radicals being reactive to carbon-containing compounds contacted by the free radicals.

31. The reticle of claim 28, wherein the photocatalytic material is selected from the group consisting of TiO₂, Fe₂O₃, Cu₂O, In₂O₃, WO₃, Fe₂TiO₃, PbO, V₂O₅, FeTiO₃, Bi₂O₃, Nb₂O₃, SrTiO₃, ZnO, BaTiO₃, CaTiO₃, KTiO₃, SnO₂, ZrO₂, and compounds and mixtures thereof.

32. The reticle of claim 28, wherein the energizing wavelength is 400 nm or less.

33. An X-ray optical system, comprising a multilayer-film optical element as recited in claim 1.

34. The X-ray optical system of claim 33, further comprising:
means for directing an energizing wavelength of light to impinge on the multilayer-film optical element, and
means for introducing an oxygen-containing gas to a vicinity of the multilayer-film optical element, wherein the photocatalytic material, when illuminated by the energizing wavelength, forms oxygen free radicals from the oxygen-containing gas, the oxygen free radicals being reactive to carbon-containing compounds contacted by the free radicals.

35. An EUV optical system, comprising an EUV-reflective mirror as recited in claim 14.

36. The EUV optical system of claim 35, further comprising:
means for directing an energizing wavelength of light to impinge on the EUV-reflective mirror; and
means for introducing an oxygen-containing gas to a vicinity of the EUV-reflective mirror, wherein the photocatalytic material, when illuminated by the energizing wavelength, forms oxygen free radicals from the oxygen-containing gas, the oxygen free radicals being reactive to carboncontaining compounds contacted by the free radicals.

37. An EUV optical system, comprising a reflective reticle as recited in claim 23.

38. The EUV optical system of claim 37, further comprising:
means for directing an energizing wavelength of light to impinge on the EUV-reflective mirror; and
means for introducing an oxygen-containing gas to a vicinity of the EUV-reflective mirror, wherein the photocatalytic material, when illuminated by the energizing wavelength, forms oxygen free radicals from the oxygen-containing gas, the oxygen free radicals being reactive to carbon-containing compounds contacted by the free radicals.

39. An EUV optical system, comprising a reflective reticle as recited in claim 23.

40. The EUV optical system of claim 39, further comprising:
means for directing an energizing wavelength of light to impinge on the EUV-reflective mirror; and
means for introducing an oxygen-containing gas to a vicinity of the EUV-reflective mirror, wherein the photocatalytic material, when illuminated by the energizing wavelength, forms oxygen free radicals from the oxygen-containing gas, the oxygen free radicals being reactive to carbon-containing compounds contacted by the free radicals.

41. An EUV lithography system, comprising:
an EUV source that generates an illumination beam of EUV light;
an illumination-optical system situated and configured to guide the illumination beam from the EUV source to an EUV-reflective reticle that defines a pattern to be transferred from the reticle to a lithographic substrate, wherein EUV light reflected from the reticle constitutes a patterned beam carrying an aerial image of a region of the reticle illuminated by the illumination beam; and
a projection-optical system situated and configured to guide the patterned beam from the reticle to the lithographic substrate, thereby transferring the pattern from the reticle to the substrate, wherein at least one of the illumination-optical system, the reticle, and the projection-optical system includes at least one EUV-reflective optical element that comprises (1) a multilayer film comprising alternating first and second layers laminated superposedly relative to each other, each first layer being formed of a first substance exhibiting a relatively large difference between its refractive index for EUV light and a refractive index in a vacuum, and each second layer being formed of a second substance exhibiting a relatively small difference between its refractive index for EUV light and the refractive index of a vacuum; and (2) a protective layer situated superposedly relative to an uppermost layer of the multilayer film, the protective layer comprising a photocatalytic material; and
means for introducing an oxygen-containing gas to a vicinity of the EUV-reflective optical element, wherein the photocatalytic material, when illuminated by an energizing wavelength of light, forms oxygen free radicals from the oxygen containing gas, the oxygen free radicals being reactive to carbon-containing compounds contacted by the free radicals.

42. The EUV lithography system of claim 41, wherein at least one of the illumination-optical system and projection-optical system further comprises means for irradiating light of the energizing wavelength on the at least one EUVreflective optical element, the energizing wavelength being 400 nm or shorter.

43. The EUV lithography system of claim 41, further comprising means for irradiating, separately from EUV light passing through the illumination-optical system and projection-optical system, light of the energizing wavelength on at least one EUV-reflective optical element, the energizing wavelength being 400 nm or shorter.

44. The EUV lithography system of claim 43, wherein:
at least the last optical element of the projection-optical system is a said EUV-reflective optical element; and
the means for irradiating is situated so as to irradiate the last optical element with the energizing wavelength.

45. The EUV lithography system of claim 41, wherein the projection optical system comprises:
multiple multilayer-film mirrors each configured as a respective EUV-reflective optical element; and
means for irradiating light of the energizing wavelength, of 400 nm or shorter, on the multilayer-film mirror situated as the last multilayer-film mirror from which the patterned beam reflects to the lithographic substrate.

46. An X-ray lithography system, comprising:
an X-ray source configured to produce an illumination beam;
an illumination-optical system situated and configured to guide the illumination beam from the X-ray source to a selected region on a reflective reticle defining a lithographic pattern to be transferred to a sensitive substate, wherein the illumination beam reflected from the reticle constitutes a patterned beam carrying an aerial image of the illuminated region; and
a projection-optical system situated and configured to guide the patterned beam from the reticle to the sensitive substrate, so as to transfer the pattern from the reticle to the sensitive substrate,
wherein the reflective reticle comprises a reticle substrate, an X-ray-reflective multilayer film formed on the reticle substrate and having an upper surface, an absorbing-body layer formed on the upper surface of the multilayer film, the absorbing-body layer being segmented into individual absorbing bodies separated from one another on the upper surface according to the pattern, and a protective layer comprising aphotocatalytic material formed on the upper surface of the multilayer film and between the upper surface and the absorbing bodies.

47. The system of claim 46, wherein the reflective reticle further comprises a second protective layer, comprising a photocatalytic material, formed over the absorbing bodies and over regions of the upper surface situated between the absorbing bodies.

48. An X-ray lithography system, comprising:
an X-ray source configured to produce an illumination beam;
an illumination-optical system situated and configured to guide the illumination beam from the X-ray source to a selected region on a reflective reticle defining a lithographic pattern to be transferred to a sensitive substrate, wherein the illumination beam reflected fromthe reticle constitutes a patterned beam carrying an aerial image of the illuminated region; and
a projection-optical system situated and configured to guide the patterned beam from the reticle to the sensitive substrate, so as to transfer the pattern from the reticle to the sensitive substrate,
wherein the reflective reticle comprises a reticle substrate, an X-ray-reflective multilayer film formed on the reticle substrate and having an upper surface, an absorbing-body layer formed on the upper surface of the multilayer film, the absorbing-body layer being segmented into individual absorbing bodies separated from one another on the upper surface according to the pattern, and a protective layer comprising a photocatalytic material coating the absorbing bodies as well as intervening regions of the upper surface.

49. In an EUV lithography system that includes an EUV-reflective optical element that includes a multilayer-film interference coating, a method for preventing accumulation of contaminants on a reflective surface of the optical element, the method comprising:
applying a protective layer to the reflective surface, the protective layer comprising a photocatalytic material;
in the presence of an oxygen-containing gas, directing light of a photocatalytically energizing wavelength to impinge on the protective layer so as to cause the photocatalytic layer to generate oxygen free radicals from the gas; and
allowing the oxygen free radicals to react with the contaminants and form volatile by-products.

50. The method of claim 49, further comprising the step of removing the volatile by-products.

51. The method of claim 49, wherein the oxygen-containing gas is selected from the group consisting of oxygen, water vapor, and hydrogen peroxide, and mixtures thereof.

52. In an EUV lithography system that includes an illumination-optical system, a projection-optical system, and an EUV-reflective reticle that includes a multilayer-film interference coating and a patterned absorbingbody layer formed over the interference coating, the absorbing-body layer being segmented into individual absorbing bodies separated from one another on the interference coating according to a pattern, a method for preventing accumulation of contaminants on the reticle, the method comprising:
applying a protective layer to the reticle in a manner such that the protective layer covers regions of the interference coating between the absorbing bodies as well as respective upper surfaces of the absorbing bodies, the protective layer comprising a photocatalytic material;
in the presence of an oxygen-containing gas, directing light of a photocatalytically energizing wavelength to impinge on the protective layer so as to cause the photocatalytic layer to generate oxygen free radicals from the gas, and
allowing the oxygen free radicals to react with the contaminants and form volatile by-products.

53. The method of claim 52, further comprising the step of removing the volatile by-products.

54. The method of claim 52, wherein the oxygen-containing gas is selected from the group consisting of oxygen, water vapor, and hydrogen peroxide, and mixtures thereof.
